(19) **Europäisches Patentamt**

**European Patent Office**

**Office européen des brevets**

(11) **EP 1 437 424 A2**

(12) **EUROPEAN PATENT APPLICATION**

(43) Date of publication:
**14.07.2004 Bulletin 2004/29**

(51) Int Cl.7: **C23C 14/02**, C23C 14/22

(21) Application number: **03253404.2**

(22) Date of filing: **30.05.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **31.05.2002 US 159134**

(71) Applicant: **Veeco Instruments Inc.**
**Woodbury, NY 11797 (US)**

(72) Inventors:
• **Kools, Jacques C. S.**
**Sunnyvale, California 94086 (US)**
• **Devasahayam, Adrian J.**
**Woodmere, New York 11598 (US)**

(74) Representative: **Gillard, Matthew Paul et al**
**Withers & Rogers,**
**Goldings House,**
**2 Hays Lane**
**London SE1 2HW (GB)**

(54) **Method and apparatus for smoothing surfaces on an atomic scale**

(57) A method and an apparatus for smoothing surfaces on an atomic scale. The invention performs smoothing of surfaces by use of a low energy ion or neutral noble gas beam, which may be formed in an ion source or a remote plasma source. The smoothing process may comprise a post-deposition atomic smoothing step (e.g., an assist smoothing step) in a multilayer fabrication procedure. The invention utilizes combinations of relatively low particle energy (e.g., below the sputter threshold of the material) and near normal incidence angles, which achieve improved smoothing of a surface on an atomic scale with substantially no etching of the surface.

**EP 1 437 424 A2**

**Description**

FIELD OF THE INVENTION

This invention generally relates to the fabrication of multilayer materials and more particularly, to a method and an apparatus for smoothing metal surfaces on an atomic scale in a multilayer fabrication process.

BACKGROUND OF THE INVENTION

Multilayers are created during the fabrication of various materials, such as Giant MagnetoResistance (GMR) materials, Tunneling MagnetoResistance (TMR) materials, Extreme Ultra Violet (EUV) Mirrors, and X-ray Mirrors. These multilayer materials are composed of a plurality of individual layers, some of which may be metallic. Each individual layer's thickness is comparable to the characteristic length scales of atomic processes, such as the scattering length for conduction electrons. As a result, the properties of the multilayer as a whole are quite different from the properties of its individual layers.

The generic fabrication sequence of a multilayer material typically consists of consequent vacuum deposition of the individual layers in a single vacuum run. The individual layers may be deposited by several techniques, including but not limited to Molecular Beam Epitaxy (MBE), Physical Vapor Deposition (PVD) or Ion Beam Deposition (EBD). The contamination level and latency time between subsequent depositions must be sufficiently low to avoid contamination of the interface between layers. During the fabrication of multilayers, it is desirable, and often essential, to have interfaces between the individual layers that are flat and sharp on the atomic level,

The morphology of the interface will be dictated by the surface morphology of the lower film after completion of its deposition. Therefore, in order to achieve flat interfaces, it is important to ensure that the surface of the lower film is as flat as possible prior to the deposition of the subsequent layer.

One prior method to obtain smooth surfaces is referred to as "ion polishing". In this process, the surface is subjected to an ion beam generated in a broad beam ion source. Examples of this type of process are described in U.S. Patent Number 5,529,671 ofDebley et al., U.S. Patent Number 6,368,664 of Veerasamy et al., and Hoffman et al. "Ion Polishing of Metal Surfaces," Optical Engineering, Vol. 16, pp. 338-346 (July-August 1977). An example of an ion source that may be used in this type of process is described in U.S. Patent Number 3,156,090 of Kaufman. In an ion polishing process, ions are accelerated to energies in the range of a few hundred to a few thousand electronVolts (eV), and are incident to the target surface at oblique angles (i.e., angles more than 45 degrees off the surface normal). This type of treatment is found to lead to a significant reduction of the surface roughness. Because the energies used in this process are above the "sputter threshold," these processes remove significant amounts ofmaterial from the target surface.

Ion polishing has been applied to the fabrication of metallic multilayers. Examples of these applications are described in Miayamoto et al. "Investigations of GMR Characteristics and Crystal Structures for $Ni_{81}Fe_{19}$/Cu Multi-layers with Ar Ion Bombardment on Interfaces," IEEE Transactions On Magnetics, Vol. 32, No. 5, pp. 4719-4721 (Sept. 1996); and Tsunekawa et al. "Effect of plasma treatment on the GMR properties of PtMn-based synthetic spin-valves," presented at 46th conference on Magnetism and Magnetic Materials, BD-04, Seattle Washington, November 12-16, 2001. In these prior art multilayer fabrication teachings, the surface of a freshly formed constituent layer is subjected to ion bombardment without breaking vacuum to improve the surface morphology. The Miayamoto et al. reference describes using ion beams with relatively high beam energies (eg., 100 eV and above) at off-normal angles to improve surface morphology (i.e., to smooth the metal surface). The Tsunekawa et al. reference describes the use of "RF sputter etching," which also involves the use of relatively high ion energies above the sputter threshold.

Because all of the foregoing smoothing methods involve removal of material from the sample or substrate, multilayer fabrication procedures employing these prior methods must compensate for the resulting difference in the desired thickness of the respective layers that form the multilayer material. For instance, the removal of material in the smoothing step may be compensated for by initially depositing a layer or film that is thicker than the target value, but that reaches the target value after the etching. These compensation procedures are undesirable in a multilayer fabrication. For example and without limitation, when forming ultrathin films, the subtractive smoothing process often causes variations which are undesirable in a mass fabrication process. Furthermore, the etched surfaces often lack the precise level of flatness that is necessary or desirable in a multilayer fabrication process. This lack of precision or "error" is compounded at each interface and can adversely affect the overall properties and reproducibility of the resulting multilayer.

There is therefore a need for an improved method and apparatus for smoothing surfaces on an atomic scale, which may be used in a multilayer fabrication process, and which provides precise smoothing without substantial etching or removal of material.

SUMMARY OF THE INVENTION

The present invention provides a method and an apparatus for smoothing surfaces on an atomic scale. In one embodiment, the invention smoothes a surface on an atomic scale by use of a low energy ion or neutral noble gas beam formed in an ion source or a remote plasma source. The smoothing process may comprise a post-deposition atomic smoothing step (e. g., an assist smoothing step) in a multilayer fabrication procedure. The present invention utilizes combinations of particle energy and incidence angles, which achieve improved smoothing of a surface, such as a metal surface, on an atomic scale with substantially no etching of the surface. These conditions, namely, the use of low energy particles at an angle of incidence relatively close to normal, are significantly different from conditions used in the prior art, and provide significant advantages over the prior art.

One non-limiting advantage of the present invention is that it provides a method and an apparatus for smoothing a surface on an atomic scale for use in a multilayer fabrication process, which results in improved smoothing of the surface with substantially no etching.

Another non-limiting advantage of the present invention is that it allows the post deposition step of smoothing a surface to be performed in the same machine as the deposition process, thereby decreasing the chance of contamination of the material, reducing the overall production time, and increasing the throughput of a multilayer fabrication process.

Another non-limiting advantage of the present invention is that it provides a method and an apparatus for smoothing metal surfaces on an atomic scale which utilizes a relatively low energy ion beam treatment process at near normal angles of incidence to provide improved smoothing of metal surfaces without etching of the surfaces.

According to a first aspect of the present invention, an apparatus is provided for smoothing a surface of a material on an atomic scale. The apparatus includes a chamber in which the material is disposed; and a source which is disposed in the chamber and which provides a beam of particles which impact the surface with a relatively low energy, effective to cause smoothing of the surface with substantially no etching of the surface.

According to a second aspect of the present invention, a method is provided for smoothing a surface of a material on an atomic scale. The method includes exposing the surface to a beam of particles having a relatively low energy, effective to smooth the surface without etching the surface. The angle that the beam impacts the surface is preferably close to normal incidence.

According to a third aspect of the present invention, a method is provided for forming a metallic multilayer material. The method includes the steps of: forming a first layer of material having a surface; generating a beam of particles having an energy below a sputter threshold of the material; causing the beam of particles to impact the surface at an angle relatively close to a normal angle of incidence, effective to smooth the surface without etching the surface; and depositing a second layer of material on the smoothed surface.

These and other features, aspects and advantages of the invention will become apparent by reference to the following specification and by reference to the following drawings.

BRIEF DESCRIPTION OF THE DRAWINGS

Figure 1 is a schematic diagram of an exemplary apparatus that may be used to smooth surfaces on an atomic scale, according to one embodiment of the present invention.

Figure 2 is a partially sectioned perspective view of an ion or a particle source that may be used in the apparatus shown in Figure 1.

Figure 3 is a top view of an exemplary cluster tool that may incorporate an apparatus for smoothing metal surfaces on an atomic scale, according to one embodiment of the present invention.

Figure 4 is a schematic diagram of an exemplary multi-target apparatus that may be used to smooth metal surfaces, according to another embodiment of the present invention.

Figure 5 is a flow chart illustrating a method for smoothing a surface on an atomic scale, according to one embodiment of the present invention.

Figure 6 is a graph illustrating experimental film smoothness results for various angles of incidence and particle energies.

Figure 7 is a graph illustrating experimental film etch rate results for various angles of incidence and particle energies.

Figure 8 illustrates a model of a Cu (111) surface used in simulations of the present invention.

Figure 9 is a graph illustrating etch rate versus incidence angle for an Ar particle beam on a Cu (111) surface with varying ion energy.

Figure 10 is a graph illustrating smoothing efficiency as a function of incidence angle for an Ar particle beam on a Cu (111) surface with varying ion energy.

Figure 11 is a graph illustrating the smoothing efficiency of various noble gases on a Cu (111) surface at an ion energy of 60 eV.

DETAILED DESCRIPTION OF THE EMBODIMENTS

The present invention will now be described in detail with reference to the drawings, which are provided as illustrative examples of the invention so as to enable those skilled in the art to practice the invention. The preferred embodiment of the method and apparatus for smoothing surfaces on an atomic scale is described in relation to a metal surface in a multilayer fabrication procedure. However, it will be appreciated by those skilled in the art that the present invention is equally applicable to other types of surfaces and procedures. For instance, one of ordinary skill in the art will appreciate that the present invention may also be applied to smooth non-metal surfaces on an atomic scale, such as but not limited to Diamond Like Carbon (DLC) surfaces, glass surfaces, $Al_2O_3$ surfaces, $SiO_2$ surfaces, and the like.

The discussion below describes the present invention in the following manner: (i) Section I describes an exemplary apparatus that may be used to smooth surfaces on an atomic scale, according to one embodiment of the present invention; (ii) Section II describes a method for smoothing surfaces on an atomic scale, according to one embodiment of he present invention; and (iii) Section III provides results of modeling experiments of the preferred method and apparatus.

I. EXEMPLARY APPARATUS

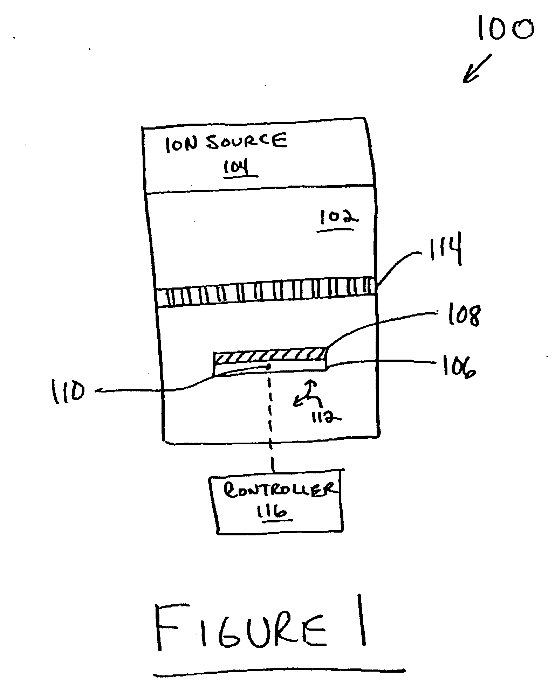

Figure 1 illustrates an exemplary apparatus 100 that is adapted to perform smoothing of surfaces on an atomic scale, according to one embodiment of the present invention. The deposition or "beam treatment" apparatus 100 may be a stand-alone module or assembly or may comprise a portion or module of a cluster tool, as described below. While the following discussion relates to apparatus 100, the present invention may be implemented using other suitable deposition devices, components and accessories, as would be apparent to those of ordinary skill in the art, and the figures and examples below are not meant to limit the scope of the present invention. Moreover, where certain elements of the present invention can be partially or fully implemented using known components, only those portions of such known components that are necessary for an understanding of the present invention will be described, and detailed descriptions of other portions of such known components will be omitted so as not to obscure the invention.

Apparatus 100 includes a vacuum chamber 102, having a particle beam source, such as a remote plasma source or ion source 104, and a sample stage or carrier 106, which is adapted to hold a substrate or material 108, such as a metal film or multilayer material. Apparatus 100 may also include one or more conventional collimation devices, assemblies or members, such as but not limited to a physical collimator 114. The collimation devices, assemblies or members may assist in collimating particles emitted from the plasma or ion beam source 104, such that the ions or particles are incident upon the material 108 at a predetermined angle (e.g., a substantially normal angle). In one embodiment, sample stage 106 may be selectively tiltable, rotatable and/or positionable about an axis 110 in the directions of arrows 112. The tiltable stage 106 allows the angle of incidence of the emitted ions on the surface of material 108 to be selectively controlled, such as by use of a conventional controller 116 (e.g., a servo-controller). Particularly, the controller 116 can transmit control signals to tiltable stage 106, which may include a conventional motor or other controllably movable device, which is effective to cause the angle of incidence to remain fixed at normal (and/or relatively close to normal) incidence, or to be variable (e.g.. to move stage 106 in the directions of arrows 112).

In the one embodiment, the remote plasma or ion source 104 comprises a downstream high-density plasma or ion source, such as a Radio Frequency Inductively Coupled Plasma (RF-ICP) source or an Electron Cyclotron Resonance (ECR) source. The source 104 may be an ion source adapted to emit various charged particles or ions, such as but not limited to noble gas ions (e.g., Ar, Xe, Kr, Ne ions), with a range of controllable energies. Importantly, the ion source 104 is adapted to emit ions with relatively low energies, such as but not limited to energies below the sputter threshold of the target material 108. In one non-limiting embodiment, source 104 may emit particles with energies in the range of 20 eV to 40 eV. Ion source 104 may also be capable of emitting ions at lower energies and at much higher (e.g., sputtering or etching) energies. In alternate embodiments, source 104 may comprise a remote plasma source, i.e., a plasma source that is disposed at a relatively remote proximity from the stage 106, effective to provide a beam of particles that impact material 108 at a substantially normal angle of incidence, and at other angles of incidence relatively close to normal. In other alternate embodiments, source 104 may be a source adapted to provide a beam of neutral particles (e.g., neutral noble gas molecules) that impinge upon material 108 at a substantially normal angle of incidence. Sources for providing a beam of neutral particles are known in the art. One non-limiting example of such a source is described in Nonaka et al. "Laser Ablation of Solid Ozone," Materials Research Society Symposium, vol. 617, pp. J1.3.1 -J1.3.6 (2000), which is fully and completely incorporated herein by reference. In any of these embodiments, the particle beam emitted or provided by the source 104 will be of relatively low energy (e.g., below the sputter threshold of material 108) and will impact the material 108 at a substantially normal angle of incidence or an angle relatively close to the normal angle of incidence.

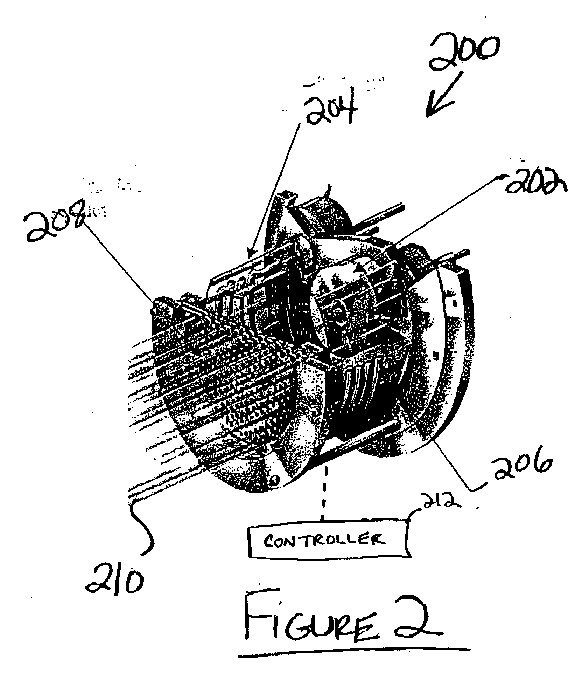

Figure 2 illustrates an RF-ICP source apparatus 200, which may be adapted for use as the ion source 104, according to one embodiment of the invention. Source apparatus 200 includes a source inlet 202, a quartz discharge chamber 204, which receives and discharges the gas particles, an RF helical coil 206, and a plurality of grids 208, which assist in charging or energizing the particle beam 210 to a desired energy as it is emitted from source inlet 202. Apparatus 200 may also include a controller 212, which is adapted to provide control signals to apparatus 200 and/or grids 208, effective to charge grids 208 to a certain potential such that the beam particles in beam 210 have a relatively low energy (e.g., an energy below the sputter threshold of the material 108). One of ordinary skill in the art will appreciate how to program or operate controller 212 and/ or grids 208 in order to cause the particles of beam 210 to have a relatively low energy (e.g., an energy below the sputter threshold of matirial 108).

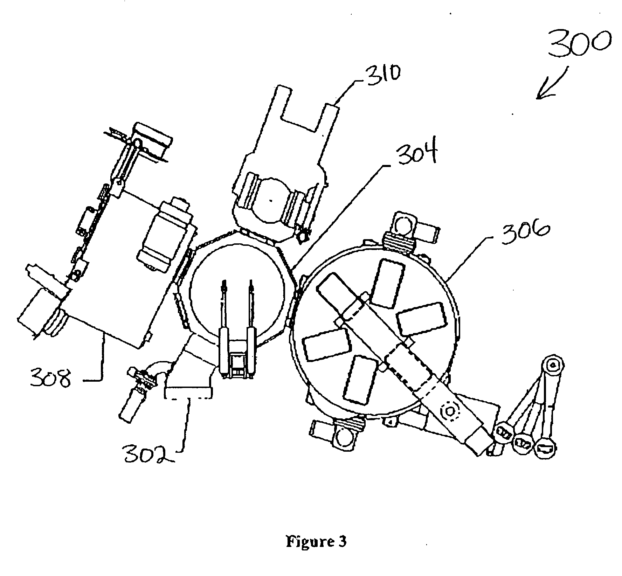

In one embodiment, the deposition apparatus 100 may be integrated as a module of a multi-chamber cluster tool. Figure 3 illustrates an exemplary cluster tool 300 that may be used to perform a multilayer fabrication process, including the smoothing of metal surfaces, according to one embodiment of the present invention. The cluster tool 300 includes a vacuum cassette elevator 302 for loading wafers into tool 300, and a central handling assembly 304, which transfers wafers between a plurality of modules or process chambers 306, 308 and 310 under vacuum conditions. Each process chamber 306 - 310 may correspond to a certain step in a multilayer fabrication procedure, such as a deposition step, a treatment step and/or a polishing step. A substrate may be loaded into the central handier assembly 304 transferred from chamber to chamber to perform a multilayer fabrication in a manner known to those of ordinary skill in the art. In the preferred embodiment, module 306 comprises a conventional multi-target planetary Physical Vapor Deposition (PVD) module, module 308 comprises a conventional Ion Beam Deposition module, and module 310 comprises a smoothing module adapted to perform the smoothing process of the present invention. Particularly, module 310 may comprise a beam treatment or smoothing apparatus, which is substantially similar to apparatus 100, shown in Figure 1. Ailer a film or layer of material is deposited on the substrate, the substrate may be transferred to the smoothing module 310 so that the surface of the material can be precisely smoothed before the next layer of material is deposited on the substrate. By allowing all smoothing and fabrication or deposition procedures to occur within the same tool, throughput is desirably increased and the chance for contamination or damage to the substrate is desirably reduced.

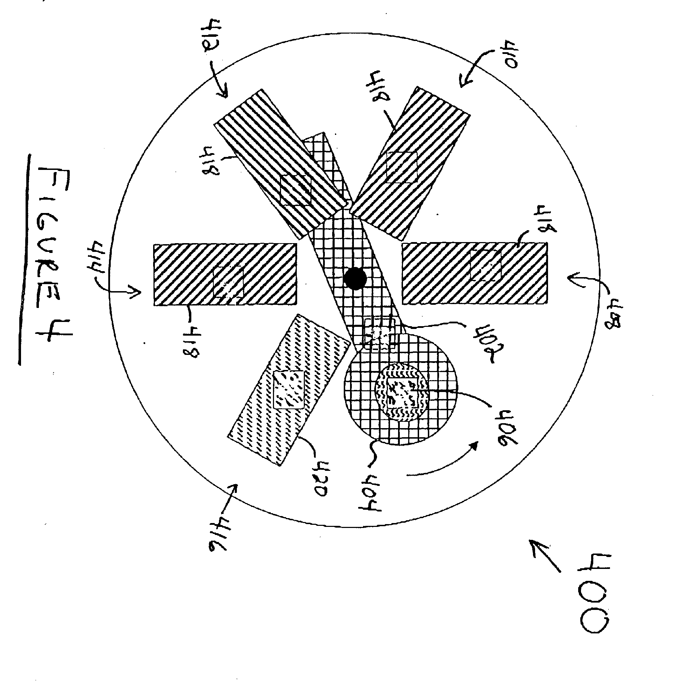

According to another embodiment, the smoothing or beam treatment procedure of the present invention may be performed within a multi-target deposition module, such as the exemplary multi-target deposition module 400, illustrated in Figure 4. Module 400 maybe substantially similar in structure to a conventional multi-target deposition module, such as the PVD module 306 of Figure 3, with the exception of the low energy particle or ion source 420, which is mounted within one of the portions of module 400 in a conventional manner.

The module 400 includes a selectively rotatable "J"-arm 402, including a carrier or stage portion 404 on which a substrate or wafer 406 may be disposed, and a plurality of process sections or portions 408 - 416. Each of portions 408, 410, 412 and 414 may include a conventional sputter cathode 418 for depositing a film of material on wafer 406. However, in section 416, sputter cathode 418 has been replaced with a low energy particle or ion source 420, which may be substantially identical to source 104. In this manner, portion 416 may provide a beam treatment or smoothing process portion of module 400. In alternate embodiments, different and/or additional portions 408 - 416 may include a source 420 and comprise beam treatment or smoothing process sections.

In operation, one or more of portions 408 - 414 may deposit one or more layers of material on a substrate or wafer 406. After the deposition procedure(s), J-arm 402 moves the wafer 406 to portion 416 of the module to undergo beam treatment or smoothing, according to the present invention (i.e., the newly formed surface will be smoothed but not etched by impacting it with relatively low energy particles at a substantially normal angle of incidence). Once the surface has been smoothed, the wafer 406 may be transported to the other portions 408 - 414 of the module to receive one or more additional layers of material. This procedure may be repeated until the desired multilayer material is formed. This embodiment has the advantage of minimizing the substrate or wafer handling time.

## II. METHOD FOR SMOOTHING METAL SURFACES ON AN ATOMIC SCALE

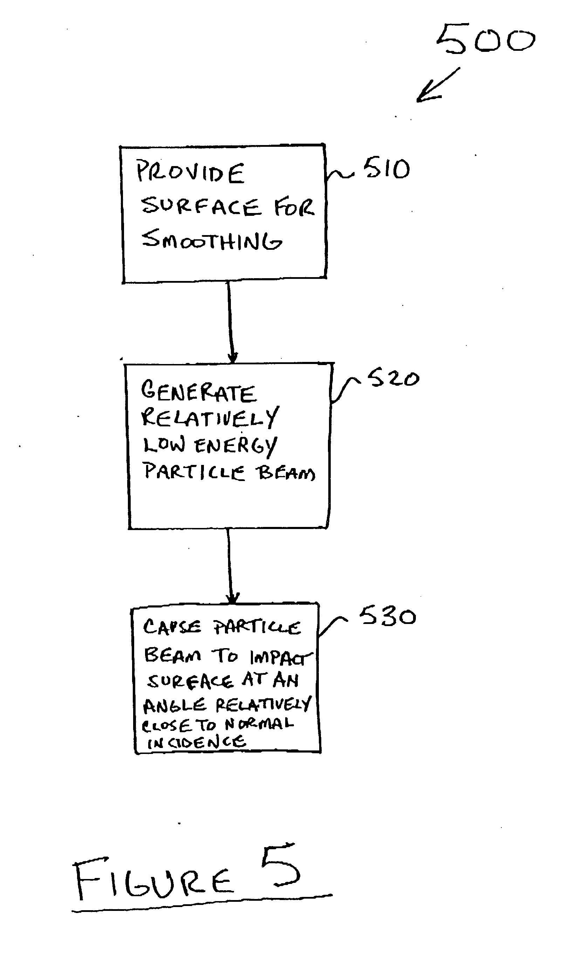

Figure 5 is a flow chart 500 illustrating a general methodology for smoothing a surface on an atomic scale, according to one embodiment of the present invention. The method begins with functional block or step 510, where a surface for smoothing is provided. As described above, the surface may comprise a metal surface (e.g., a Cu (111) surface) that forms a portion or layer of a metallic multilayer material. The surface may also comprise a surface of any other suitable non-metal or crystalline material, where the formation of a precise flat surface is desired. In functional block or step 520, a beam of relatively low energy particles is generated. As described above, the beam may comprise a beam of ionized or neutral noble gas particles having a relatively low energy, and may be generated in any suitable manner. For example, in one embodiment, the beam is generated by use of the source 200, illustrated in Figure 2, and is energized to a desired level by use of grids 208. In the preferred embodiment, the average energy of the particles is below the sputter threshold of the surface material, and in one embodiment the particle energy is in the range of 20-40 eV. In the example of a Cu surface, the preferred particles may comprise ionized Xe. Kr and/ or Ar gas particles having energies in the range of 20-40 eV. In the case of Cu surfaces, Xe and Kr particles have been shown to be more efficient than Ar particles. In functional block or step 530, the beam of relatively low energy particles is caused or directed to impact the target surface at an angle relatively close to the normal angle of incidence of the surface. In the preferred embodiment, the angle of impact may be in the range of 0 to 30 degrees off normal. The length of time that target surface is exposed to the beam to achieve optimal smoothing will depend on the type of material, particles and energies used in the procedure. In one embodiment, surface roughness decreases with time, followed by a saturation at a certain level. Particularly, after a certain predetermined period of time has elapsed, which in one embodiment may be in the range of 100-200 seconds, the surface will achieve a desired or precise level of smoothness. After this predetermined period of time, the surface will only experience minimal additional smoothing, and step 530 may be terminated.

If the smoothing method 500 is being employed as part of a multilayer fabrication procedure, after the surface is smoothed (e.g., after step 530), the material may undergo a deposition procedure, wherein another layer or film is deposited on the surface. The method 500 may be performed on the newly formed surface, and the entire procedure may be repeated until the multilayer is formed.

It should be appreciated that the smoothing method and/or apparatus may be employed as a "standalone" application for other types of surface preparation procedures. For example, the method and apparatus may be used to smooth noble metal surfaces (or metal surfaces which do not oxidize in the presence of air), such as gold or platinum, and may form a surface preparation step in any fabrication process, such as a nanotechnology fabrication process, where the formation of precisely flat surfaces is necessary or desirable.

It should further be appreciated by those skilled in the art, that similar smoothing effects could be obtained with other combinations of noble gases and particles and for various metal and non-metal surfaces by selecting particle energies slightly below the sputter threshold and by varying the ion/particle species and angle of incidence. Various combinations of ion/particle energy mass and angle will be most efficient for a given metal (e.g., element or alloy) or non-metal crystalline surface. These conditions can be determined on a case-to-case basis using the method and apparatus described above, and the experimental models described below.

III. RESULTS OF MODELING EXPERIMENTS

Modeling experiments were performed to confirm the results provided by the present invention. The modeling experiments were performed on a copper (111) surface. However, it will be appreciated to those skilled in the art that the conclusions may be extrapolated for other metals, materials and crystalline orientations. The modeling experiments used a vacuum integrated cluster tool which contained a multi-chamber Physical Vapor Deposition (PVD) tool capable of depositing thin metal films with a reproducibility of approximately 1% and an Ion Beam (IB) module containing a gridded RE_ICP ion source and a tiltable stage, which allowed the angle of incidence of the particle beam on the substrate to be selectively varied.

In a first experiment, a stack consisting of 25 Å Ta/ 200 Å Cu was deposited on a wafer in the PVD module. The stack was then transferred to the IB module, and exposed to one of three types of ion assist or beam treatments:

Case 1. Plasma only

In the first or "plasma only" case, an Ar plasma was struck in the ion source and the grids were kept at a ground potential. As a result, the source generated ions with an energy equal to the plasma potential (in this case approximately 25 eV). as well as a contribution due to the plasma temperature (in this case approximately 7.5 eV).

Case 2. 40 V/40 mA

In the second or "40V/40mA" case, an Ar plasma was struck in the ion source, and the grids were activated in order to generate a particle beam having a beam energy of 40 V and a beam current of 40 mA. As a result, the average particle or ion energy in this case was approximately 65 eV.

Case 3. 75 V/75 mA

In the third or "75 V/75 mA" case, an Ar plasma was struck in the ion source, and the grids were activated in order to generate a particle beam having a beam energy of 75 V and a beam current of 75 mA. As a result, the average particle or ion energy in this case was approximately 100 eV.

In each case, after the beam exposure or treatment, the wafer was transferred back to the deposition chamber, and covered with a 25 Å Ta capping layer.

The wafer was subsequently transferred to air, and sheet resistance and surface roughness were measured by four-point probe and atomic force microscopy, respectively. Since Ta has a resistivity which is much higher than Cu (180 μΩcm versus 3 μΩcm), the majority of the current is carried by the Cu layer, and any resistance variation can be directly correlated to Cu thickness variations. Provided the thickness variations are small (e.g., < 10%), it is appropriate to assume a constant copper resistivity.

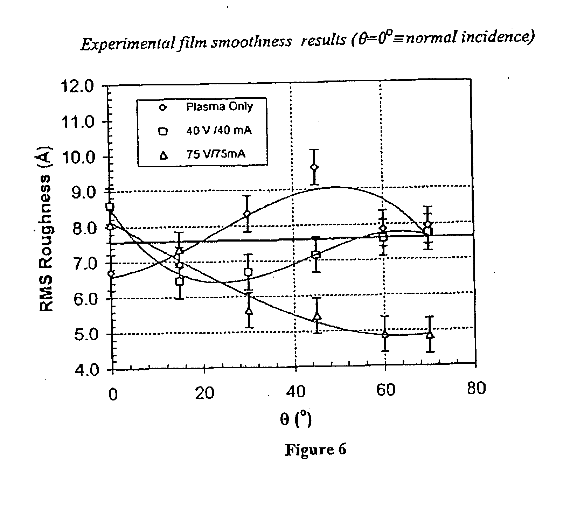

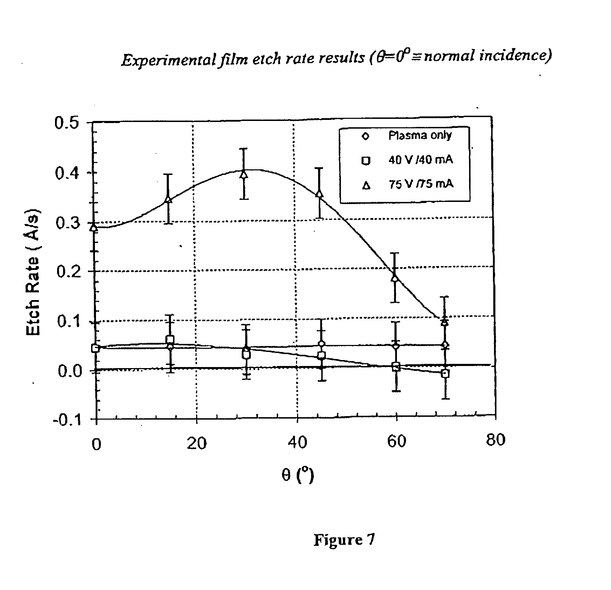

The experimental results for each of the cases are summarized in the graphs illustrated in Figures 6 and 7. Particularly, Figure 6 illustrates experimental film smoothness results for various angles of incidence and particle energies, and Figure 7 illustrales experimental film etch rate results for various angles of incidence and particle energies. The initial RMS roughness is approximately 7-6 Å. From the results shown in Figure 6, it is apparent that the angle where optimal smoothing occurs is not the same for all energies. The higher energy process has its best performance (most efficient smoothing) at far off-normal angles, consistent with prior art.

However, the data corresponding to the teachings of the present invention (i.e., lower energy data, at near normal incidence) confirms the advantages and benefits of the present invention over conventional smoothing processes. Particularly, by using relatively low energy particle beams, the most optimal smoothing now occurs at near normal incidence, and as shown in Figure 7, the resulting etch rate is substantially zero (e. g., within the error of the measurement zero or negligible).

The beam treatment method and apparatus of the present invention that provides for in-situ smoothing with negligible etching has significant practical implications. For example, experimental data indicates that by applying such a beam treatment or smoothing step in the deposition sequence of a GMR material leads to a significant (e.g., >10 %) improvement of its magnetoresistance ratio and reduction of the interlayer coupling.

A molecular dynamics simulation of a model system may be used in order to further appreciate the underlying mechanism of the present invention. A Kalypso Molecular Dynamics package was used to perform such a simulation. In the simulation, the repulsive parts of the potentials are of the Ziegler-Biersack-Littmark (ZBL) screened Coulomb potential type. The attractive Cu-Cu potential is a tight-binding many body potential.

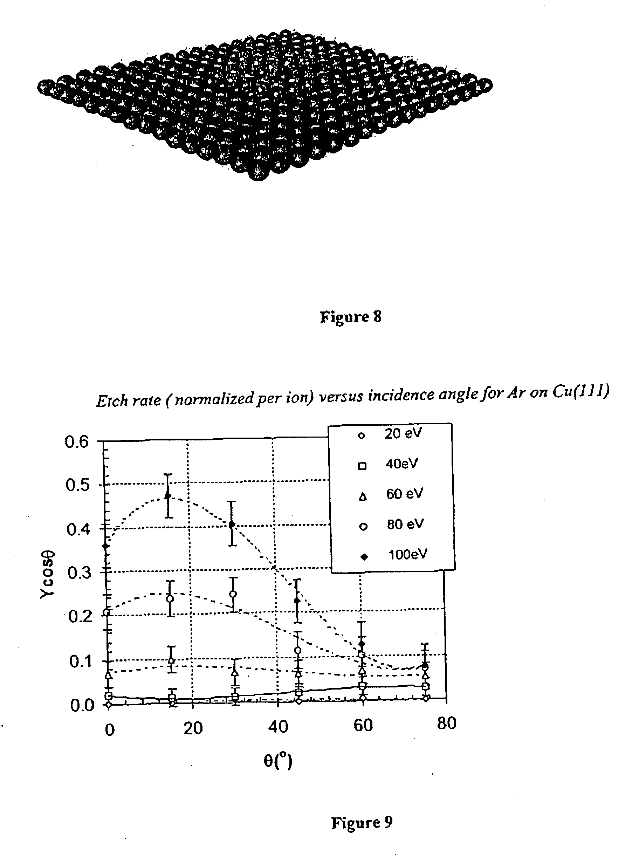

In the simulation, the substrate is a 17x17x9 atom (111) Cu crystallite, with a two-layer island positioned on top, as illustrated in Figure 8. The island has 25 atoms in the first level, and 9 atoms in the second. The simulation sequence consists of calculating a series of 600 trajectories at any given energy and polar angle. The impact points were sampled on a 10 Å by 10 Å square grid, which partly overlapped with the island. Six azimuthal angles were averaged. The following parameters were extracted from the calculation:

The sputter yield: Y
The average change in number atoms level n: $\delta_n$
The smoothing efficiency v, which is defined as:

$$v=(\delta_2-\delta_0)\cos\theta, \qquad (1)$$

where $\theta$ is the angle of incidence of the particle beam.

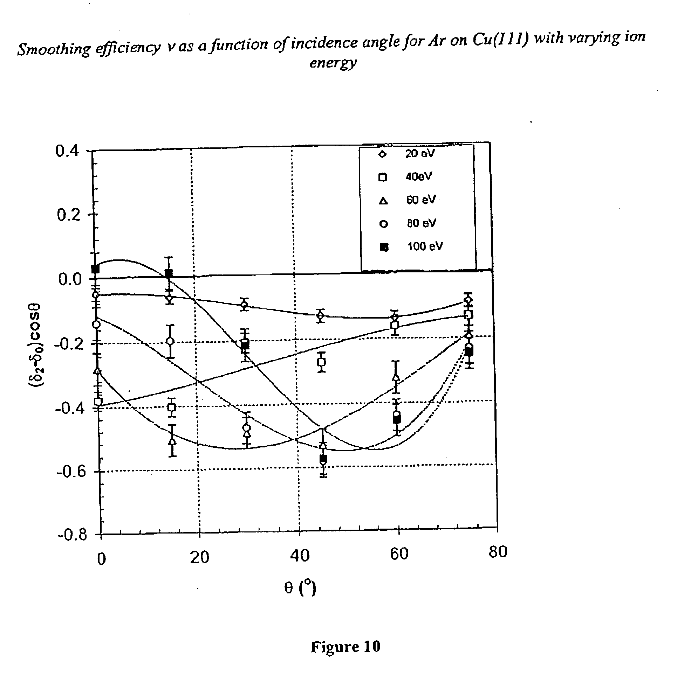

Figures 9 and 10 illustrate the results of the simulation for ion energies of 20, 40, 60, 80 and 100 eV. The etch rate data confirms that the so-called sputter threshold occurs at about 40 $e^V$, as shown in Figure 9.

Therefore, ion energies below this value will induce negligible etching. However, the smoothing efficiency v has a finite value at 40 eV. The smoothing efficiency decreases with ion energy, and substantially disappears for ion energies around 20 eV.

The results shown in Figure 10, further illustrate that the angle of maximal smoothing efficiency varies with energy, and confirm the efficacy of the present invention by demonstrating that improved smoothing with negligible etching occurs at near normal incidence, for ion energies in the 20-40 eV range.

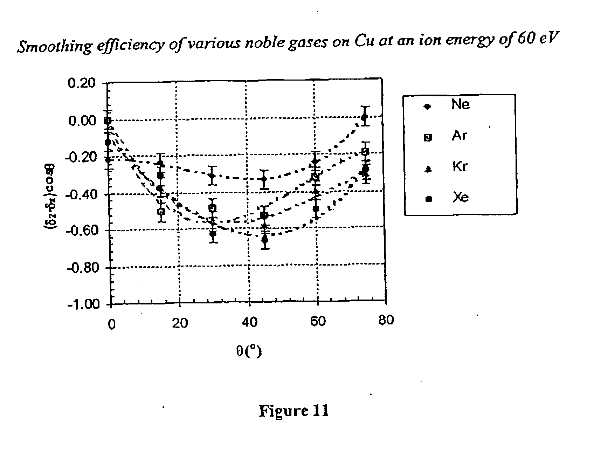

Another set of simulations was performed to illustrate the effect of different noble gas projectiles on the smoothing efficiency at a fixed ion energy of 60 eV. The results of these simulations are shown in Figure 11. The following can be concluded from these simulations. The optimal impact angle or angle of incidence depends on the mass of the ion. At 60 cV, the optimal angle for Xe is further off normal than for Ar. Furthermore, the smoothing efficiency depends strongly on the ion mass. For example, it is apparent that Ne on Cu is less efficient than Ar on Cu, while Xe and Kr on Cu is more efficient.

Therefore, in view of these findings, it will be apparent to those skilled in the art, that optimal smoothing effects can be obtained with various combinations of noble gases and particles by selecting particle energies slightly below the sputter threshold and by varying the ion/particle species and angle of incidence based on the type of metal or non-metal surface that is being smoothed. Various combinations of ion/particle energy mass and angle will be most efficient for a given metal (e.g., element or alloy) or non-metal crystalline surface. These conditions can be determined on a case-to-case basis employing the foregoing method, apparatus and experimental modeling procedures.

While the foregoing has been with reference to particular embodiments of the invention, it will be appreciated by those skilled in the art that changes in these embodiments may be made without departing from the principles and spirit of the invention, the scope of which is defined by the appended claims.

**Claims**

1. An apparatus for smoothing a surface of a material on an atomic scale, the apparatus comprising:

   a chamber in which the material is disposed; and
   a source which is disposed in the chamber and which provides a beam of particles which impact the surface with a relatively low energy, effective to cause smoothing of the surface with substantially no etching of the surface.

2. The apparatus of claim 1 wherein the relatively low energy is below a sputter threshold of the material.

3. The apparatus of claim 2 wherein the relatively low energy is in the range of 20eV to 40eV.

4. The apparatus of claim 1 wherein the source provides a beam of ionized particles.

5. The apparatus of claim 4 wherein the ionized particles are noble gas molecules.

6. The apparatus of claim 1 wherein the source provides a beam of neutral particles.

7. The apparatus of claim 1 wherein the beam of particles impacts the surface at an angle relatively close to a normal angle of incidence.

8. The apparatus of claim 7 wherein the angle of impact is in the range of 0 to 30 degrees off normal.

9. The apparatus of claim 1 further comprising:

   a stage which is disposed in the chamber and which is adapted to hold the material.

10. The apparatus of claim 9 wherein the stage is selectively tiltable, effective to alter the angle that the beam of particles impacts the surface of the material.

11. The apparatus of claim 1 further comprising:

   at least one deposition chamber for depositing a layer of material on the surface; and
   a movable device for transporting the material between the chamber and the at least one deposition chamber.

12. The apparatus of claim 1 wherein the chamber is a multi-target chamber, including a first portion containing the source, and at least one second portion for depositing a film on the material.

13. The apparatus of claim 12 further comprising a movable arm for transporting the material between the first and at least one second portion of the chamber.

14. A method for smoothing a surface of a material on an atomic scale comprising the step of:

   exposing the surface to a beam of particles having a relatively low energy, effective to smooth the surface without etching the surface.

15. The method of claim 14 wherein the relatively low energy is below the sputter threshold of the material.

16. The method of claim 15 wherein the relatively low energy is in the range of 20 eV to 40 eV

17. The method of claim 15 further comprising the step of causing the beam of particles to impact the surface at an angle relatively close to a normal angle of incidence.

18. The method of claim 17 wherein the angle of impact is in the range ofO to 30 degrees off normal.

19. The method of claim 18 wherein the particles comprise ionized noble gas particles

20. The method of claim 19 wherein the particles comprise neutral particles.

21. The method of claim 14 wherein the surface comprises a metal surface.

22. The method of claim 14 wherein the surface comprises a non-metal crystalline surface.

23. The method of claim 14 wherein the step of exposing the surface to a beam of particles having a relatively low energy, effective to smooth the surface without etching the surface, is performed as part of a nanotechnology fabrication process.

24. A method for forming a metallic multilayer material, comprising the steps of:

   forming a first layer of material having a surface;
   generating a beam of particles having an energy below a sputter threshold of the material;
   causing the beam of particles to impact the surface at an angle relatively close to a normal angle of incidence, effective to smooth the surface without etching the surface; and
   depositing a second layer ofmaterial on the smoothed surface.

25. The method of claim 24 wherein the first layer of material comprises copper.

26. The method of claim 25 wherein the beam of particles comprises ionized noble gas particles.

27. The method of claim 26 wherein the ionized noble gas particles are selected from the group consisting of Xe, Ar, Kr and Ne particles.

28. The method of claim 26 wherein the energy is in the range of 20 eV to 40 eV.

29. The method of claim 28 wherein the angle of impact is in the range of 0 to 30 off normal.

100

ION SOURCE
104

102

114

108

106

110

112

CONTROLLER
116

FIGURE 1

FIGURE 2

Figure 3

FIGURE 4

500

PROVIDE
SURFACE FOR
SMOOTHING — 510

GENERATE
RELATIVELY
LOW ENERGY
PARTICLE BEAM — 520

CAUSE PARTICLE
BEAM TO IMPACT
SURFACE AT AN
ANGLE RELATIVELY
CLOSE TO NORMAL
INCIDENCE — 530

FIGURE 5

*Experimental film smoothness  results ($\theta=0^{\circ}\equiv normal\ incidence$)*

Figure 6

*Experimental film etch rate results ($\theta=0^o \equiv normal\ incidence$)*

Figure 7

Figure 8

*Etch rate ( normalized per ion) versus incidence angle for Ar on Cu(111)*

Figure 9

16

*Smoothing efficiency ν as a function of incidence angle for Ar on Cu(111) with varying ion energy*

**Figure 10**

*Smoothing efficiency of various noble gases on Cu at an ion energy of 60 eV*

Figure 11